(19)

Europäisches
Patentamt

European
Patent Office

Office européen
des brevets

(11) **EP 4 700 481 A1**

(12) **EUROPEAN PATENT APPLICATION**

(43) Date of publication:
**25.02.2026 Bulletin 2026/09**

(21) Application number: **24195199.5**

(22) Date of filing: **19.08.2024**

(51) International Patent Classification (IPC):
*G03F 7/20* (2006.01)

(52) Cooperative Patent Classification (CPC):
**G03F 7/70616; G03F 7/706841; G06N 3/045;
G06N 3/047; G06N 3/08; G06N 7/01; G06N 20/00;
G06N 20/10**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **ONOSE, Alexandru**
**5500 AH Veldhoven (NL)**

• **VENSELAAR, Joannes, Jitse**
**5500 AH Veldhoven (NL)**
• **BOTARI, Tiago**
**5500 AH Veldhoven (NL)**
• **CRAMER, Hugo, Augustinus, Joseph**
**5500 AH Veldhoven (NL)**
• **INVERNIZZI, Andrea**
**5500 AH Veldhoven (NL)**

(74) Representative: **ASML Netherlands B.V.**
**Corporate Intellectual Property**
**P.O. Box 324**
**5500 AH Veldhoven (NL)**

(54) **DIFFUSION MODELS FOR PARAMETER INFERENCE WITH APPLICATION TO WAFER METROLOGY**

(57) A generative network, conditioned on metrology data obtained from at least one patterned substrate, is used to process an input, to generate an output. The input is substrate model data defining a substrate model of the at least one substrate, and the output of the generative network is used to produce updated substrate model data defining an updated substrate model. In one or more further iterations, the generative network processes an input based on the updated substrate model generated in the preceding operation. The output of the generative network in the last iteration is used to generate substrate description data describing the at least one substrate.

Fig. 6

EP 4 700 481 A1

# Fig. 9

S701 → | obtaining metrology data |

S702 → | at least one iteration of processing, by the diffusion model conditioned on the metrology data, an input comprising current substrate model data, to generate updated substrate model data |

S703 → | generating the substrate description model based on the updated model produced in the last iteration |

## Description

### FIELD

The present invention relates to systems and methods for processing metrology data of a patterned portion of at least one substrate (e.g. a wafer of semiconductor material), to generate a model of the patterned portion of the at least one substrate. The present invention also relates to systems and methods for training a diffusion model to process model data defining a model of a patterned portion of at least one substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

After a substrate has been patterned using the lithographic apparatus, it is often desirable to inspect the substrate (i.e. to measure properties of the patterned structure), e.g. to determine whether the produced pattern accurately resembles the intended design. To this end, a metrology system (e.g. optical metrology systems, scanning electron microscopes (SEM), soft x-ray metrology systems, and the like) can be used to acquire metrology data (any measured signals such as image(s)) of the patterned substrate. The acquired metrology data is often further processed using specialised algorithms to infer an estimate of one or more parameters of interest such as parameters defining a physical model of the patterned substrate (e.g. when the intended pattern includes a stack of layers, the parameters may define a "parametrized" model that describes a stack geometry). The so-determined parameters of interest can be used to adjust process parameters (e.g. scanner settings or conditions, etch process parameters, and the like) which specify the manufacturing process of the patterned substrate e.g. to improve performance and yield of the semiconductor devices made with the same manufacturing process. The parameter of interest can also be a parameter that directly relates to a process parameter.

Sometimes (e.g. in "non-linear" cases for which the inverse solution is not known or at least not readily available), the parameters of interest are inferred by iteratively solving an optimization problem. In these cases, a (physics-derived) forward model is used (i.e. a simulation model that generates predicted metrology data from input parameters that define a model of the patterned structure and a model of the metrology system). The forward model is repeatedly used while varying (optimizing) the parameters in order to minimize the difference between the acquired metrology data and the predicted metrology data in some metric. The set of model input parameters that give a sufficiently close match are considered to be a good indication of the parameters of the measured structure During the optimization process, the parameter values can be selected (i.e. varied) in different ways, e.g. by random sampling or by using a mathematical optimization algorithm. The selection strategy is often chosen based on the characteristics of the forward model and the parameter space (some known algorithms use prior knowledge of the parameter space).

However, the aforementioned, state-of-the-art algorithms for processing metrology data have disadvantages. As one example, these algorithms require repeated evaluations of computationally intensive forward models. As another example, some of these algorithms use only "local" information, e.g. a part of the metrology data relating only to parts of a wafer which are close to a stack of which the structure is to be inferred. Consequently, these algorithms are prone to getting stuck in local minima. It is therefore desirable to provide improved techniques for processing metrology data. A further problem is that the parameters used in the parameterized model are critical to its performance. That is, the modelling technique may fail if the parameterized model does not correspond sufficiently to the real substrate. For example, the patterned substrate may have an extra layer produced by oxidation which the model does not include.

SUMMARY

The present invention aims to provide new and useful methods and systems for obtaining substrate description data which characterises a model ("substrate model") of a patterned portion of one or more substrates, from metrology data. The substrate model is a mathematical/computational representation of the substrate. For example, the substrate description data may comprise one or more numerical parameters defining the substrate model. The metrology data comprises data output by a metrology system (also called here "tool"). The metrology system comprises one or more sensors which collect and detect radiation that has interacted with, and hence contains information about, the patterned portion of the one or more substrates and output measured signals such as images. In general the measured signals may be 1-dimensional, 2-dimensional or even higher dimensional data.. As described below, the metrology data may further comprise configuration data describing the at least one sensor (e.g. the type of the sensor(s) and/or calibrations (settings) of the sensor(s)) and the metrology system (e.g., the intensity and/or spectrum of the radiation, the measurement location, and/or the orientation of the substate) at the time that they were used to perform the measurements).

In general terms, the invention proposes that a generative (neural) network, conditioned on the metrology data, is used to generate an output, and the output of the network is used to generate the substrate description data. The generative network may generate the output upon processing an input (e.g. a random input, or as described below, an input of substrate model data defining a substrate model which is to be improved) while being conditioned on the metrology data. Thus, there may be an iterative process of, in a first iteration, generating first substrate model data (e.g. from a random input), followed by one or more iterations of improving the substrate model data produced in the previous iteration, to improve its consistency with the metrology data.

In implementations of this concept, the generative model may generate the substrate model data more quickly than the known methods described above, i.e. with a lower computational burden, e.g. as measured by a number of computing operations (e.g. floating-point operations), and/or with lower memory requirements. It is also possible to address the problems of non-convexity of the solution space, which leads to the local minima in known methods.

By "generative network" is meant here an adaptive model defined by numerical parameters which have been iteratively trained, such that the generative model generates an output based on a joint probability distribution of a target dataset Y given an input dataset X received by the generative network. For example, the generative model, upon receiving an input dataset (e.g. an input to the generative model and any further data on which the generative model is conditioned), may generate an output which is a prediction (estimate) of the target dataset which is most likely given the input dataset.

In an implementation of the invention, a method may comprise multiple iterations in each of which (except optionally the first) an input to the generative model comprises a dataset ("current substrate model data") defining a current substrate model, and the output of the generative model is used to generate updated substrate model data defining an updated substrate model. The updated substrate model data can then be used to as, or more generally to define, the input to the generative model in the next iteration (if any).

Each successive updated substrate model is successively more consistent with the metrology data. For example, defining for each substrate model, a respective distance value which indicates a divergence (according to a similarity metric such as Euclidean distance) between (i) the metrology data and (ii) metrology data which would have been obtained using the at least one sensor if the updated substrate model had exactly described the at least one substrate, the respective distance values for successive updated substrate models is successively less.

The substrate description data may be based on (e.g. may be) the substrate model data generated in the last of the multiple iterations, but as described below other possibilities exist.

In principle, the generative model may take any of multiple forms (e.g. a generative model trained within a generative adversarial model).

However, in an implementation, the generative model is a diffusion model, such as one which has been trained, upon receiving an input which comprises substrate model data defining a current substrate model, to output prediction data indicative of a divergence between the current substrate model data and (presently unknown) second substrate model data which is more consistent with the first metrology data than the current substrate model data (e.g. one having a lower corresponding distance value). The target variable of the diffusion model is the prediction data, and the diffusion model outputs a prediction of the most likely prediction data, given the input and the data (including metrology data) upon which the diffusion network is conditioned. The prediction data may then be used generate the updated substrate model data, by modifying the current substrate model data based on the prediction data.

As noted above, the metrology data on which the generative model is conditioned may include sensor configuration data in addition to sensor output data. This allows tool-to-tool matching, e.g. benefitting during the training of the generative model from training data from tools of different types and/or with different settings, so that in use the generative model can benefit from all this training data in performing influence in relation to a specific tool. The configuration data may allow the diffusion model to be trained from training data comprising metrology data collected from sensors having different constructions, and/or the same construction but different calibrations when the at least one sensor was used to measure the one or more substrates (different corresponding wavelengths of incident radiation used by the sensor(s), different incidence angles, and/or different modulations of the incident radiation). Using the sensor configuration data to configure the generative model allows the generative model to be more robust to changes in the sensor which generates the sensor output data.

The generative model (e.g. diffusion model) may be conditioned on other data in addition to the metrology data. This data may encode any available information about the substrate(s) and/or the patterning process, or any available information about the substrate model which is used to define the input to the generative model.

For example, in each iteration, the generative model may be conditioned on a variable indicating the iteration. This may for example be useful in the case that the generative mode is a diffusion model, since in later iterations the magnitude of the noise described by the prediction data may be less.

In another example, the generative model is further conditioned on class data indicating a class of a structure (a "target structure") present in the patterned portion of the at least one substrate. The target structure may for example be an electronic component such as a transistor. This class data may be pre-known (e.g. it may be based on design data for the at least one substrate), or it may be class data which is inferred from a substrate model obtained during the iterative process. It may be generated by an embedding model to reduce its dimensionality.

For example, initial iterations of the method (a first phase) may be used to generate a substrate model which is used to infer a class of a structure ("target structure") present in the patterned portion of the at least one substrate (e.g. by selecting from a plurality of pre-known possible structure classes, each described by data characterizing target structures of that class). After this, one or more "later" iterations of the method (a second phase) may condition the generative model with class data indicating the class of a target structure inferred from the substrate model data obtained in the last of the initial iterations. Note that, optionally, the generative model used in the initial iteration(s) may be a first trained generative model, and the generative model used in the one or more later iteration(s) may be a different, trained "second" generative model which has been trained to process inputs, conditioned on the class data as well as on the metrology data.

The iterations which employ the class data may be said to produce substrate model data which is "target model data", i.e. data defining a target model which is a substrate model including one or more instances of the inferred class of the target structure. Thus, the term "target model" may be used in place of "substrate model" to describe the second phase of the process.

The second generative model may, for example, be a diffusion model, and, similarly to the processing by the first diffusion model, the second diffusion model may process the current target model data when conditioned on the metrology data (or a modified form of it; see below). Note that the data on which the second diffusion model is conditioned may be different from the (first) diffusion model described above. This process may comprise: (i) the second diffusion model generating target prediction data indicative of a divergence between the current target model data and second target model data defining a second target model which is consistent with the second metrology data than the current target model, and (ii) generating the updated target model data based on the target prediction data.

Note that optionally, the "second" metrology data on which the "second" generative model is conditioned may be different from the first metrology data upon which the first generative model (the one used in the initial iterations of the method) is conditioned. For example, it may comprise metrology data generated by fewer imaging modalities than the first metrology data.

The class data may, as noted be generated using an embedding network, such as from "structure data" (e.g. design data) descriptive of a structure of a substrate, or a portion of a substrate, of the identified class. Note that this process may be carried out in advance (e.g. before the metrology data is generated), e.g. for multiple possible identified classes, and the class data may be stored and retrieved upon the class being identified. By using the embedding network, the class data may have fewer numerical values than the structure data, or to put it another way a lower dimensionality, while retaining the most relevant information. For example, low value information in the structure data which can reduce the effectiveness of the generative model, is removed.

The embedding network may have been trained jointly with a decoding network within an auto-coder network in which the embedding network plays the role of an encoder network. Specifically, the embedding network may have been trained to generate, from given structure data, compressed structure data having a lower dimensionality than structure data, and the decoder network may have been trained to reconstruct the structure data from the compressed structure data. Following the training, the class data for the structure data of a substrate, or a portion of a substrate, of the identified class can be generated as the compressed structure which the embedding network outputs upon inputting the structure data.

Each of the substrate models (e.g. each current substrate model and each updated substrate model) may be a parametric model defined by corresponding substrate model data which comprises one or more numerical parameters (typically, a plurality of numerical parameters, such as at least 6 numerical parameters, or at least 10 numerical parameters). These parameters typically comprise parameters which describe the spatial relationship between different portions of the at least one substrate Alternatively or additionally, the parameters may comprise one of the process parameters (e.g. scanner settings or conditions, etch process parameters, and the like) which specify the manufacturing process of the patterned substrate, or a parameter indicative of the value of one of the process parameters. Updating the substrate model data may comprise, or consist of, updating the numerical parameter(s) for the substrate model data corresponding to the current substrate model, thereby forming the updated substrate model data corresponding to the updated substrate model. Thus, the substrate description data which, as noted may be generated from the updated substrate model generated in the last iteration (i.e. the final one of the iterations), and which may in fact be the substrate model data for that updated substrate model, likewise comprises one or more numerical parameters.

As noted, some or all of the one or more numerical parameters may characterize relationships between different locations in the patterned portion of the at least one substrate. For example, the numerical parameters may comprise at least one of:

> an overlay value indicative of misalignment between elements of the at least one substrate at different levels of the at least one substrate, e.g. if the at least one substrate comprises a stack of patterned layers, at least one parameter may be a numerical overlay value which indicates how much the pattern in one layer of the stack is misaligned with respect to a pattern in another layer;
> a value indicative of a shape of an element of the patterned structure;
> a value indicative of a discrepancy between one or more regions of the patterned structure and design data characterizing the patterned structure; or
> a value indicative of the setting or condition of one of the process tools used to manufacture the patterned structure, such as one that has an impact on the shape thereof.

Techniques of this kind are particularly appropriate if the metrology data comprises data obtained from one or more of optical visible light metrology, SXR (soft x-ray) metrology or high landing energy SEM (scanning electron microscope) technology (HL-SEM, since all of these are typically used to recover numerical parameters of a substrate model which describes a stack of layers.

Alternatively or additionally, the substrate model data may comprise one or more numerical values associated with only one corresponding respective location (e.g. locations which are each within a single corresponding layer) in the at least one substrate and descriptive of the at least one substrate at the corresponding associated locations (e.g. give the refractive index or transmission coefficient values for the optical response at the respective location). If the substrate model data defining the substrate model is entirely made up of values associated with and describing respective single locations in the at least one substrate (these are thus "non-geometric" parameters, which generally do not describe the position or orientation of one location of the substrate in geometric relation to another), the substrate model may be referred to as "non-parametric". Note that substrate models of this kind may be constructed without prior knowledge of critical parameters of the stack of layers of the at least one substrate.

The locations may comprise locations in a two-dimensional array, e.g. respective portions of a surface of the substrate(s). For example, each of the locations may correspond to a group of pixels in image(s) of the substrate(s) included in the metrology data. In this case, for example, the substrate description data may describe the quality of a layer of a chemical applied in a pattern to the surface of the substrate.

Alternatively or additionally, the locations may comprise locations in the at least one substrate which are in a three-dimensional array. For example, the locations may correspond to voxels of the substrate model, and may correspond to respective elements of the at least one substrate which are in an (e.g. regular) three-dimensional array within the at least one substrate. Using a voxel method in the present situation may avoid problems due to bias in the description of the substrate model.

Another form of non-parametric model is a model in one which the numerical values correspond to spatial frequency components of a spatial transform model of the at least one substrate, such as Fourier components or wavelet components. These may for example describe at least one physical property, such as a density, an impurity level or a property (e.g. a refractive index) characterizing the interaction of an electromagnetic wave with the at least one substrate. Again, the model may be two- or three-dimensional (or in principle have another dimensionality), and may comprise an (e.g. two- or three-dimensional) array of spatial frequency component values.

The at least one substrate may be patterned in several ways, and the way in which the substrate description data is used may depend upon what the pattern represents.

In one case, the at least one substrate may have been subject to surface treatment such as a development operation. In this case, the metrology data comprises after development inspection (ADI) data.

In another case, the at least one substrate may have been subject to an etching operation. In this case, the metrology data comprises after etching inspection (AEI) data.

In these cases, the substrate description data may be used to reveal a fault with the development operation or the etching operation, or any processing steps prior to the development and etching. For example, a discrepancy may be identified between the substrate description data and desired data (for example, representing a pattern which it is desired to produce on the at least one substrate), and based on the discrepancy a modification may be carried out to the way in which the development operation or etching operation is carried out in future for one or more other substrate(s).

The patterned portion of at least one substrate may have been patterned using at least one substrate processing apparatus for modifying the substrate, such as at least one lithographic apparatus (e.g. as described above), etching apparatus, deposition apparatus, etc. In this case, the method may further comprise modifying the at least one processing apparatus (e.g. lithographic apparatus) based on the generated substrate description data.

We now turn to a description of the methods in which the generative model may be formed. For simplicity, we will consider the case in which the generative model is a diffusion model, but analogous methods may be used for other generative models, for example in which the generative model is a generator model trained within a generator-discriminator system.

Specifically, in the case that generative mode is a diffusion model, the diffusion model may be trained to process substrate model data defining a substrate model of a patterned portion of at least one substrate, when the diffusion model is conditioned on metrology data of the patterned portion of the at least one substrate, to generate prediction data indicative of a divergence between the substrate model data and (at this stage unknown) second substrate model data which defines a second substrate model of the patterned portion of the at least one substrate which is more consistent with the metrology data than the substrate model. Thus, the output of the diffusion model may be used, as described above, by using the prediction data to modify the substrate model data to obtain the second substrate model data.

The training may employ a training database of training items which each comprise a tuple of (i) first substrate model data, (ii) corresponding second substrate model data and (iii) corresponding metrology data. Here the second model data defines a substrate model which is more consistent with the metrology data than the first substrate model data. It may for example be a "ground truth" substrate model, but it may more generally be a substrate model which is subject to a lower degree of noise than the first substrate model data, e.g. a substrate model from which the first substrate model data was obtained by applying noise to it. Note that the reference here to "tuples" is not intended to limit how the training database is stored, e.g. to imply that elements of the tuple are stored in adjacent memory locations or particular data structures. Nor does it limit the format in which elements of the tuple are stored. For example, rather than storing the first and second substrate model data separately, the training database may equivalently store one of these two (e.g. the first substrate data) and the difference between the two. This provides the same information content in aggregate. The possibility is particularly suitable in the case that the generative model is a diffusion model, in which the generative model is trained to output the prediction data which predicts the "noise" discrepancy between the first and second substrate model data, i.e. the difference between the first and second substrate model data.

Such tuples may be formed by simulation, i.e. using a model of the substrate stack and simulating the operation of a sensor when imaging this model to produce simulated metrology data. Alternatively, though typically more expensively, they may be formed by measuring (using at least one sensor) at least one substrate to form metrology data. As noted above, the metrology data may include not only data output by the at least one sensor by observing the patterned portion of at least one substrate, but also configuration data describing the at least one sensor, e.g. data defining a calibration setting of the at least one sensor during the observation by the sensor of the patterned portion of the at least one substrate. The measured at least one substrate is known to have a structure which corresponds to a "ground truth" substrate model defined by ground truth substrate model data. Noise may be applied to the ground truth substrate model data in each of multiple steps, to generate a sequence of items of substrate model data with successively greater levels of noise and corresponding to respective substrate models. A given one of the tuples may be formed from (i) one of the sequence of items of generated substrate model data as the first substrate model data, and (ii) the ground truth substrate model (or, in a variation, an earlier one of the sequence of items of generated substrate model data than that which is used as the first substrate model data) as the second substrate model data, and (iii) the corresponding metrology data.

The training method may comprise, for each of a plurality of the tuples, iteratively modifying one or more numerical parameters of the diffusion model to reduce a measure of the divergence between (i) prediction data output by the diffusion model upon receiving the first substrate model data of the tuple and when conditioned by the metrology data of the tuple, and (ii) a difference between the second substrate model data of the tuple and the first substrate model data of the tuple.

Each of the tuples may contain additional information.

For example, each of the tuples may comprise an index indicative of the level of divergence of the substrate model data and the ground truth model data according to a divergence metric. In other words, the index is indicative of a level of noise in the substrate model data. In this case, the diffusion model may be further conditioned on the index. In one example, the index of the tuple indicates the number of steps in which noise was applied to the second substrate model data of the tuple (e.g. the ground truth substrate model data) to generate the first substrate model data of the tuple.

In another example, each tuple may further comprise class data which is indicative of a class of a target structure described by the substrate model data, second substrate model data and metrology data of the tuple, and the diffusion model may be further conditioned on the class data. In this way, the diffusion model is trained to employ the class data to improve the accuracy of the prediction data.

In the explanation given above, the invention is expressed as a method, with various optional features. However, in another aspect, the invention proposes a computer program product comprising machine-readable instructions which, when the program is executed by a computer, cause the computer to carry out the method.

In another aspect, the invention proposes a computer system comprising a processor and a data storage device, the data storage device storing program instructions which, when executed by the processor, cause the processor to carry out the methods discussed above.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 illustrates schematically the operation of a diffusion model;
- Figure 7, which is composed of Figures 7A to 7D, illustrates the operation of a diffusion model in an embodiment of the present invention;
- Figure 8 illustrates an iterative process of using a diffusion model in an embodiment of the invention;
- Figure 9 is a flowchart of a method which is an embodiment of the invention;

- Figure 10 shows illustrates a substrate model of a semiconductor stack which uses a non-parametric representation in an embodiment of the method of Figure 9;
- Figure 11 illustrates an optional process used in an embodiment of the invention;
- Figure 12 shows an example of forward and reverse diffusion in an embodiment of the invention;
- Figure 13, which is composed of Figures 13A-13C, illustrates the use of an encoder in an embodiment of the invention;
- Figure 14 illustrates a high throughput implementation of an embodiment of the invention; and
  . Figure 15, which is composed of Figures 15A-15C, illustrates results of performing the method of Figure 9 and a specific implementation of a diffusion model suitable for use in some implementations of the method.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

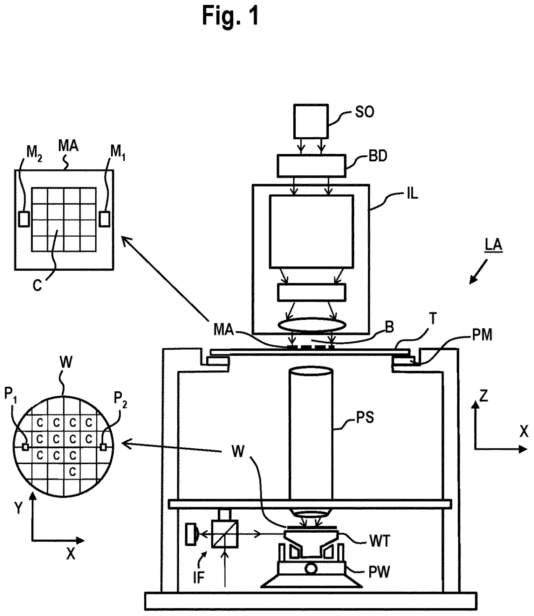

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

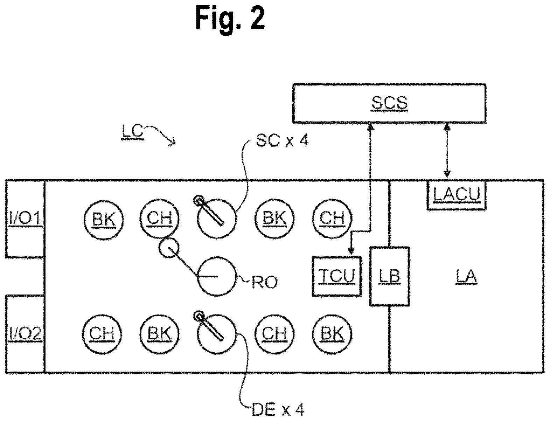

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

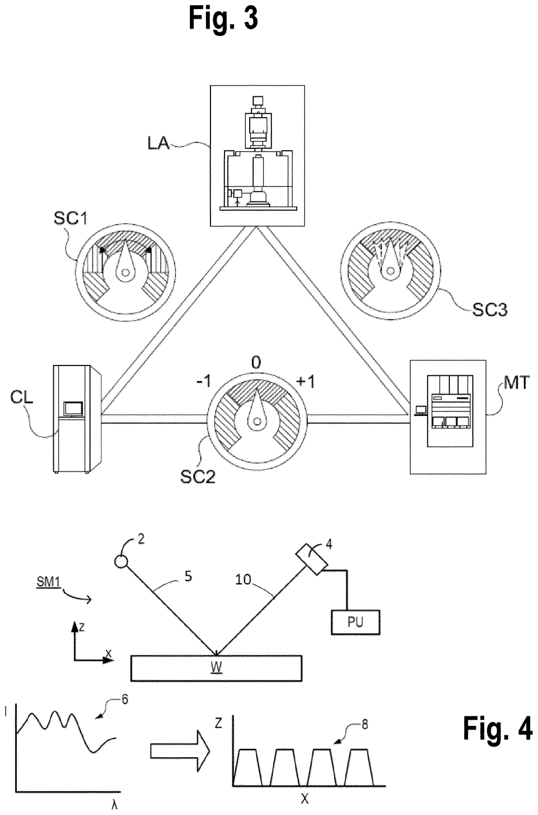

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic patterning apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

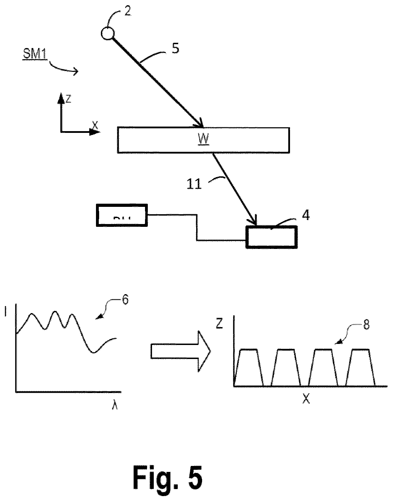

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

It is often desirable to inspect the patterned substrate using a metrology system, e.g. to determine whether the patterned substrate was fabricated correctly, and/or whether the lithographic apparatus is operating correctly or needs adjusting. Known metrology systems for inspecting patterned semiconductor wafers include for example optical (e.g. visible light) metrology systems, soft X-ray (SXR) metrology systems, high landing energy scanning electron microscopy (HL-SEM) systems. As noted above, iterative optimization based on forward models is frequently employed to infer, from the metrology data, a set of parameters defining a model of the patterned substrate.

Several semiconductor wafer metrology applications rely on parameter inference schemes. As an example, optical visible light metrology or SXR metrology may be used for profilometry of a semiconductor wafer stack. In this case, a parametrized physical stack model may be created (notably, this often requires access to potentially confidential details of the target pattern giving rise to privacy concerns). This model is used for simulating the interaction of the incidence light/X-rays with the wafer stack. Given a measured signal and a description of the sensor state, the parameters that describe the stack are inferred via an iterative optimization task (in this case, the parameters that describe the stack may describe CD values when after etching inspection (AEI) techniques are used, or a full 3-dimensional stack profilometry when SXR is used). As another example, for buried structures, the signals produced by a high landing energy SEM can typically not be directly interpreted in the same way as lower landing energy SEM measurements. In this case, a parameter inference scheme that includes a model of the stack-electron interaction is often deployed to aid reconstruction process for metrology.

The aforementioned parameter inference methods require evaluating the forward model a large number of times, which can be computationally and time intensive. Sometimes, the multiple evaluations can be speeded up by deploying an approximate or a surrogate model (instead of the physics-based forward model). However, the production of such models can lead to a high upfront cost and is typically very application specific. Also, approximate models contain systematic errors leading to errors in the parameters of the inferenced result.

Further, the known methods are also prone to getting stuck in local minima, i.e. some of the parameters are sub-optimal and further iterations do not improve the results, even though a better solution exists. Also, for the known methods, the inferred parameters strongly depend on appropriate initialization and prior knowledge of the application space, which is not always known and available (or may even be wrong).

Another problem with known methods is that many known algorithms provide poor estimates of the uncertainty of the inferred parameters. For example, the uncertainty of the inferred parameters may be estimated based on a sensitivity analysis which only quantifies the relative signal strength, not the robustness of the estimate. Bayesian optimization methods that aim to provide a statistical interpretation are difficult to set-up (since they require appropriate prior information which is typically not available) and computationally more expensive.

In addition to the aforementioned problem of iterative optimization using forward models, parameter inference is also hard because of the challenges associated with the selection of a good (i.e. suitable) physical model. Typically, the signals measured represent an incomplete or uninterpretable view on the stack properties. As such, errors in the stack geometry used during modelling cannot be readily identified from the measured signals alone and act as a bias for the inference process resulting in further errors for the parameters. Additionally, stack information may not be readily available, e.g. this information may be confidential to a different party, or features may arise during the manufacturing process that differ from the design (e.g. corner rounding effects, asymmetric etch effects, material sputtering during etch, etc.). Another problem is that the description of the stack geometry is limited by the choice of representation leading to additional errors in the inferred parameters. The inference process will not be able to account changes in the stack geometry that cannot be described by the chosen representation that is the input to the forward model, which can lead to erroneous selection of the parameters.

The inventors have realised that at least some of the aforementioned problems of known parameter inference techniques can be solved by using a trained generative model, such as a diffusion model, to infer the parameters of interest from metrology data, as described below in more detail.

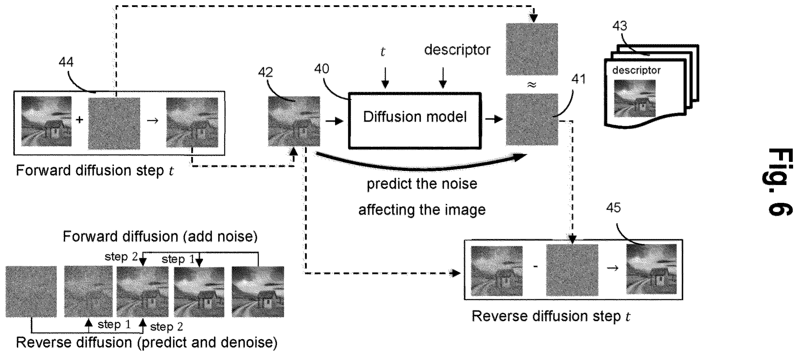

Before describing example embodiments (which employ diffusion models for inferring data (or "substrate description data") defining a model of the patterned substrate), a more general description of diffusion models is provided with reference to Figure 6. A diffusion model (e.g. diffusion model 40 in Figure 6) is a generative machine learning model that aims to learn an approximation of the probabilistic distributions of the trained data. More specifically, the model 40 is trained to predict the noise 41 that is present in an input image 42 (e.g. a scanning electron microscope (SEM) image) which is input to the diffusion model 40. This is achieved by implementing a training process where a set of training instances 43 are used as starting points for a perturbation process in which noise 44 is intentionally introduced (to mimic a diffusion process in a latent space). This process is called forward diffusion. Then, the diffusion model 40 is optimized to reverse such perturbed instances by reconstructing the original unperturbed instance. This is done through learning process where the model is optimized to predict the introduced perturbation 41 (i.e. an estimate of the noise 44) and thus remove it from the input image 42 to generate a de-noised image 45. In this way, the model learns to approximate the probability distribution of the real data 43 and therefore the manifold of the data. Once the model 40 is trained, the model 40 can be used to sample new instances in the learned manifold. This is done by starting with a random generated instance and applying the model 40 successive times until a stop criterion is satisfied. This process is known as reverse diffusion. The diffusion process implemented by model 40 can be guided by additional information that acts as an extra input to the model, e.g., using a descriptor 46 for content of each element in the dataset. This is referred to as conditioning the diffusion model 40. An additional value used to condition the diffusion model 40 may be an index t which indicates the level of noise in the image 42, e.g. the number of forward diffusion steps used to generate the input images 42.

Diffusion models, such as model 40, have been developed in the context of generating images, i.e. taking a large collection of images, a diffusion model is trained by applying noise to the image, which it then learns to extract. Starting with an image of random pixels, the diffusion model iteratively modifies the pixel values of an image to one that is close to the manifold of images the model was trained on. Additional descriptors are used to condition the diffusion model, to guide the model to predict images that match such description. These diffusion models have been successfully employed to generate images that match an input description. The inventors have realised that generative models, and in particular diffusion models similar to model 40, can be employed for processing metrology data of patterned substrates.

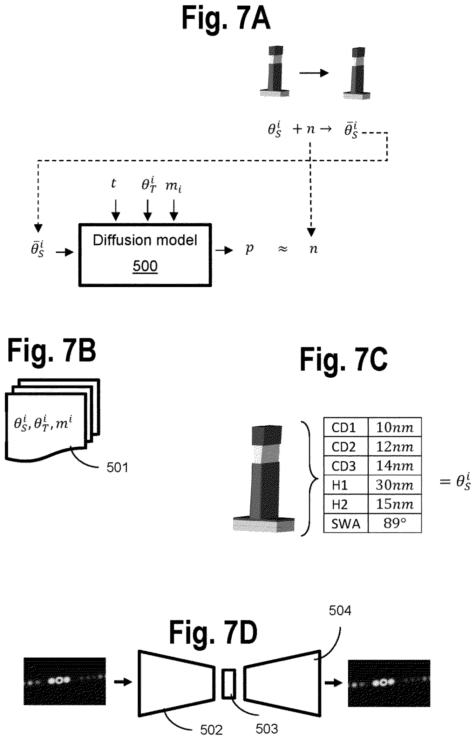

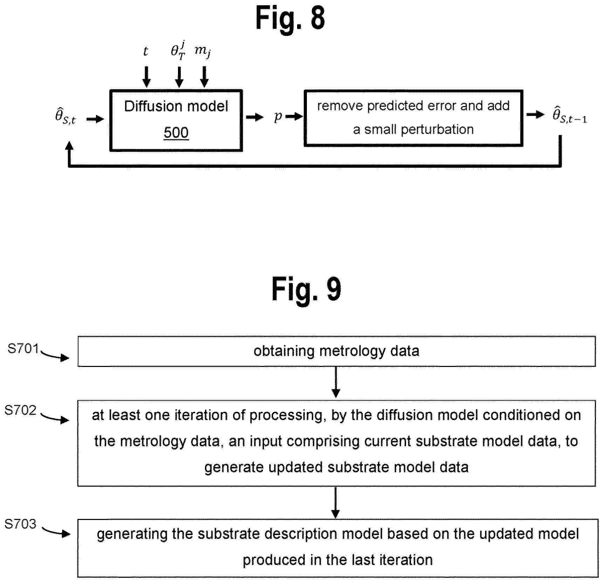

A first example diffusion model 500 for processing metrology data is now described with reference to Figures 7A-7D. The diffusion model 500 is a neural network defined by tunable numerical parameters (e.g. at least 100, at least 1000, or more numerical parameters). Once trained, the diffusion model 500 can be conditioned with metrology data of a patterned portion of a substrate (for simplicity, only one is considered), and used to process an input to generate substrate description data which characterises a substrate model of the patterned portion of the substrate, as described below with reference to Figure 8.

The patterned portion includes a stacked structure (or simply a "stack"). In this first example, the embodiment employs substrate models of the patterned portion are "parametric". This is, each substrate model is defined by a corresponding substrate model dataset which comprises a set of "stack geometry" parameters $\theta_S$ which define a parametrised stack geometry model S. The stack geometry model S is a model of the stack and may describe the dimensions of the stack and may describe further properties of the stack (e.g. parameters of interest for each of the layers of the stack, e.g. a critical dimension (CD), side wall angle (SWA), and the like). The way in which the stack geometry model S is parametrized may be selected based on domain knowledge (e.g. the intended design of the stack). The stack geometry model is defined by a set of the parameters.

The metrology data includes (i) data output ("measurements m" hereafter) by sensor(s) generated by observing the stack, and (ii) tool configuration data $\theta_T$ describing the sensor(s) during the observation by the sensor(s) of the stack. The tool configuration data $\theta_T$ may, for example, identify a type of the metrology tool (e.g. a manufacturer designation of the model of the sensor) and/or comprise data defining a calibration setting of the sensor(s) during the observation. The metrology data may be generated using any suitable metrology system/-tool, e.g. using HV-SEM, SEM, soft X-ray, etc. It may include data generated by multiple sensors, e.g. of different types. In this case the tool configuration data may include a component for each of the sensors. The measurements m are a function of the S and $\theta_T$; that is, $m = M(T(\theta_T), S(\theta_S))$.

The model 500 is configured and trained to receive, as input, i) an approximation $\overline{\theta}_S$ of the stack geometry parameters $\theta_S$, ii) measurements m, iii) configuration data $\theta_T$, and iv) and an index t indicating a diffusion step number, and to generate, based on the input, a prediction p of noise present in the input parameters $\theta_S$.

Before describing how the trained model 500 can be used to infer parameters of the stack geometry model from metrology data, an example training process of the model 500 is described. The model 500 is trained using a training database derived from a plurality of substrate training elements 501(shown in Figure 7B) labelled by an integer index *i*.

Each substrate training element comprises (i) a ground truth substrate model defined by ground truth substrate model data $\theta_S^i$ which is a plurality of stack geometry parameters, (ii) tool configuration data $\theta_T^i$, and iii) measurements $m^i$ (generated using a metrology system configured according to configuration data $\theta_T^i$ to inspect a stack described by the stack geometry parameters $\theta_S^i$) (the index "i" indicates the i-th substrate training element of the plurality of substrate training elements).

The substrate training elements 501 may be generated using real-world substrates and metrology systems or simulated one. More specially, the training measurements $m^i$ can include data acquired with a real-world metrology system inspecting a real-world stack, and/or synthetic data simulated using a (e.g. physics-based) computational model of a metrology system inspecting the stack. Accordingly, the configuration data $\theta_T^i$ may characterize a real-world or a simulated metrology system. Similarly, the "ground truth" stack geometry parameters $\theta_S^i$ may be associated with simulated stack geometry properties. When real-world measurements are used, the stack geometry parameters $\theta_S^i$ may be obtained in any suitable manner, e.g. using the above described conventional methods of iteratively using a forward model or by using high-precision (but perhaps resource/time expensive) measurement techniques (e.g. atomic force scanning probe microscopy, transmission electron microscopy measurements, etc.). Example stack geometry parameters $\theta_S^i$ are illustrated in Figure 7C in which the stack geometry parameters $\theta_S^i$ includes critical dimension values (CD1, CD2, CD3), height values (H1, H2) and a side wall angle (SWA) value.

The substrate training elements are used to generate a training database of training items. To generate a first training item, a substrate training element is selected (e.g. the "i-th" substrate training element), and a forward diffusion step is applied to the stack geometry parameters $\theta_S^i$ of the selected substrate training element. Specifically, a perturbation "n" (e.g. random noise) is applied to the stack geometry parameters $\theta_S^i$ (keeping the training measurements $m^i$ and the configuration data $\theta_T^i$ fixed) to generate perturbed stack geometry parameters $\bar{\theta}_S^i$, e.g $\bar{\theta}_S^i = \theta_S^i + n$, as illustrated in Figure 7A. A "training item" (tuplet) is then formed comprising the perturbed stack geometry parameters $\bar{\theta}_S^i$ ("first substrate model data"), the corresponding ground truth model $\theta_S^i$ ("second model data"), and the corresponding metrology data (i.e. $\theta_T^i$ and $m^i$).

This process may be repeated for the same substrate training element 501 for a multiple diffusion steps, T, labelled by integer index *t=1,...,T*, to generate a succession of corresponding training items also labelled by *t*. Here *t=1* corresponds to the first training item described above. In each diffusion step except the first (i.e. for *t=2,...,T*), the perturbed stack geometry parameters generated in the preceding step are further perturbed to generate a further set of further perturbed stack geometry parameters, and a corresponding tuple is formed. Each of the *t* tuples may include the index t which indicates the level of noise in the first substrate model data of the corresponding tuple. Thus, the tuple is $\bar{\theta}_S^i$ ("first substrate model data"), $\theta_S^i$ ("second model data"), the corresponding metrology data (i.e. $\theta_T^i$ and $m^i$) and $t$. Note that, for simplicity, $\bar{\theta}_S^i$ is here not given an index, but it could more correctly be designated as $\bar{\theta}_S^{i,t}$. The number of diffusion steps $T$ may be selected such that, at the end of the forward diffusion process, the perturbed stack geometry parameters are substantially uncorrelated with the metrology data, e.g. appear to be completely random.

Note that using a given substrate training element 501, it is possible to produce multiple sets of T training items, with different realizations of the noise at each diffusion step.

Furthermore, a data augmentation process may optionally be performed to increase the number of substrate training items. Specifically, the metrology data for a given substrate training element may be modified, thereby producing a new substrate training element, to simulate machine-to-machine variations in the sensor(s). The new substrate training element may be used to generate multiple training items in the manner described above.

Using these techniques, a training database of training items is produced. The training of the diffusion model 500 is performed over a plurality of training steps. In each training step, the diffusion model 500 processes data from one of the training items. Specifically, the perturbed stack geometry parameters $\bar{\theta}_S^i$ is input to the diffusion model 500 when the diffusion model is condition on the corresponding training measurements $m^i$ and the configuration data $\theta_T^i$, and the diffusion model 500 generates a prediction p of the perturbation n. The diffusion model 500 is trained (i.e. the values of the parameters defining the diffusion model 500 are adjusted) so as to minimize a measure of a discrepancy between the prediction p and the perturbation n (or equivalently, to minimize a measure of a discrepancy between the $\bar{\theta}_S^i$ - p and $\theta_S^i$ ).

In some implementations, an embedding (neural network) model may be used to generate an embedding $\tilde{m}$ of the input measurements m, and the diffusion model may be conditioned on the embedding $\tilde{m}$ of the input measurement rather than directly the measurement m. The embedding $\tilde{m}$ of the input measurement has a smaller dimensionality (i.e. a smaller number of numerical values) than the measurement m. In this case, Figure 7A is varied by replacing $m_i$ with $\tilde{m}_i$, where $\tilde{m}_i$ is the result of processing the measurement data $m_i$ with the encoder model 502.

As illustrated in Figure 7D, an auto-encoder architecture may be used to train the embedding model as an encoder (neural network) model 502 of an encoder-decoder system. In this example, the encoder model 502 is configured to generate an embedding 503 of an input SXR measurement and a decoder (neural network) 504 is configured to reconstruct the input SXR measurement from the embedding 503. The encoder model 502 (and the decoder 504) can be trained jointly (i.e. by interleaved or substantially simultaneous updates to numerical parameters defining the encoder 502 and the decoder 504) before training the diffusion model 500. The training of the encoder and decoder may use a larger dataset than the training of the diffusion model, because training the encoder 502 does not require that the parametrization $\theta_S$ is available, but only measurements m. Consequently, in practice, a much larger training dataset may be available.

The use of the encoder 501 may be particularly advantageous when real-world measurements are used for which the identification of the stack properties $\theta_S$ is typically expensive. For example, in some cases, a large amount of measurement training data for training the encoder 502 may be readily available but expensive estimations of $\theta_S$ are only needed for a limited subset of this training data. Because the embedded measurement $\tilde{m}$ 503 has a smaller dimensionality (i.e. a smaller number of numerical values) than the measurement m, the diffusion model 500 may be defined by a smaller number of numerical values to achieve the same accuracy of the output, so a reduced amount of the expensive training items are needed to train it.

In some implementations, the encoder 502 (and decoder 504) may be trained together with the model 500. Similarly, in some implementations, an appropriately trained encoder (not shown) may be used for generating an embedding of the tool configuration data $\theta_T$ and the diffusion model 500 may be configured to process this embedding rather than the configuration data $\theta_T$.

With reference to Figure 8, an example iterative process will now be described. This process is how the trained diffusion model 500 can be used to infer substrate model data (e.g. stack geometry parameters $\theta_S^j$ ) from a measurement $m_j$ and the corresponding tool configuration data $\theta_T^j$. In broad terms, this is achieved by "reversing" the diffusion process. Specifically, the (trained) diffusion model 500 is configured to process a "random" input which is substrate model data. In a first iteration, this may be random data, e.g. random stack geometry parameters. The trained diffusion model 500 is applied at least once to "de-noise" the random input. The output of the diffusion model 500 is an estimate p of the noise in the input ("predicted error"). This is removed from the substrate model data input to the diffusion model, to generate updated substrate model data.

In the case, that the trained diffusion model 500 is applied more than once (i.e. in multiple iterations), in each iteration (except the first) the diffusion model receives as its input a substrate model which has been updated based on the output of the diffusion model 500 in the previous iteration. In this way, the diffusion model 500 may be applied multiple times, e.g. until a convergence criterion is satisfied (e.g. the estimated noise p has a magnitude, according to a magnitude measure, below a threshold). Note that an index $t$ labels the iteration, and decreases from an initial value (e.g. $T$ as defined above), e.g. by one in each iteration. Thus, the index t indicates an expected amount of noise in the input to the diffusion model 500 during the iteration. The substrate model data input to the diffusion model 500 is denoted $\hat{\theta}_{S,t}$ and the updated substrate model data is denoted $\hat{\theta}_{S,t-1}$, which is $\hat{\theta}_{S,t}$-p.

Turning to Figure 9, a flowchart is given of the process of generating substrate description data using the trained diffusion model in the manner shown in Figure 8.

In initial step S701 metrology data is obtained. The metrology data may comprise the measurement $m_j$

and the corresponding tool configuration data $\theta_T^j$ .

In step S702, an initial guess of the desired stack geometry parameters is formed (e.g. randomly), to be used as an input to a generative model. In the case that the generative model is a diffusion model, the initial guess is $\hat{\theta}_{S,t}$ in the notation of Figure 8. The initial guess $\hat{\theta}_{S,t}$ is "de-noised" over one or more iterations using the trained generative model, e.g. trained diffusion model 500, such as by the process shown in Figure 8.

In particular, in the case that the generative model is diffusion model 500, in each "de-nosing" iteration, the diffusion model 500 is conditioned by the metrology data (the measurement $m_j$ and the corresponding

tool configuration data $\theta_T^j$ ) and preferably also by a value of the index $t$. The value of $t$ falls by one in each iteration, e.g. from being $T$ in the first iteration. In each iteration $t$, the current stack geometry parameters $\hat{\theta}_{S,t}$ (or, more generally, current substrate model data $\hat{\theta}_{S,t}$, since as described below it is possible for each substrate model data to be non-parametric) are processed by the diffusion model 500 to generate updated stack geometry parameters $\hat{\theta}_{S,t-1}$. In the first iteration, the current stack geometry parameters $\hat{\theta}_{S,t}$ are given by the initial guess (which may comprise randomly selected values for the stack geometry parameters). For each subsequent iteration, the current stack substrate model data (e.g. stack geometry parameters) of the iteration corresponds to the updated substrate model data (e.g. updated stack geometry parameters) generated in the immediately preceding iteration.

Note that, in each iteration, to generate the updated substrate model data $\hat{\theta}_{S,t-1}$, the diffusion model 500 is conditioned on (i.e. receives as an input) the metrology data and preferably on the index t, and used to process the current stack geometry parameters $\hat{\theta}_{S,t}$, to generate (or predict) prediction data p (which is indicative of a divergence between the current substrate model data (e.g. stack geometry parameters) $\hat{\theta}_{S,t}$ and substrate model data (e.g. other stack geometry parameters) which is more consistent with the metrology data than the current stack geometry parameters $\hat{\theta}_{S,t}$. The updated substrate model data (e.g. stack geometry parameters) $\hat{\theta}_{S,t-1}$ are then generated by modifying the current stack geometry parameters $\hat{\theta}_{S,t}$ based on the prediction data p. For example, the updated substrate model data $\hat{\theta}_{S,t-1}$ may be generated by subtracting the prediction data p from the current substrate model data $\hat{\theta}_{S,t}$ (i.e. $\hat{\theta}_{S,t-1} = \hat{\theta}_{S,t} - p$). In some implementations, the updated substrate model data $\hat{\theta}_{S,t-1}$ may be generated by subtracting the prediction data p from the current substrate model data $\hat{\theta}_{S,t}$ and by adding a small perturbation $\varepsilon$ (i.e. $\hat{\theta}_{S,t-1} = \hat{\theta}_{S,t} - p + \varepsilon$, where a magnitude of the perturbation $\varepsilon$ is smaller than a magnitude of the prediction data p).

At step S703, a final result (referred to as the "substrate description model") is generated and output (e.g. displayed to an operator, or transmitted to another computer system, or input to a control system of the substrate patterning equipment which produced the at least one substrate). This is may be denoted $\theta_S^j$ . It is the best estimate produced by the method of ground truth substrate model data, e.g. the actual stack geometry parameters of the substrate. The substrate description data is based on the updated substrate model data (e.g. stack geometry parameters) produced in the last iteration (i.e. the last of the one or more iterations performed in step S702). For example, the updated stack geometry parameters produced in the last iteration may simply be provided as the substrate description data $\theta_S^j$ .

As noted above, the substrate models used in the embodiments may be based on parameters which are known to be important for the substrate. For example, the patterned substrate may be produced from design data characterizing structure which is a "target structure" (e.g. an electronic component such as a transistor). The numerical parameters may be ones which are critical values describing how multiple locations on the substrate are mutually located and orientated in the substrate.

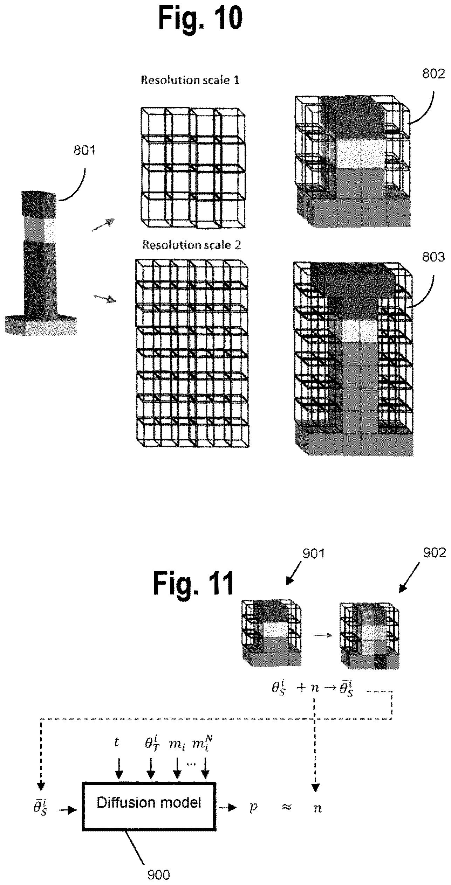

However, in some cases it can be hard to select an appropriate parametrization of the patterned substrate, e.g. when detailed knowledge of the target design is not available. A system will now be described with reference to Figures 10 to 14, which overcomes this problem by using diffusion models to generate, from metrology data, a non-parametric representation of the patterned substrate. While the described system may be adapted to generate a range of the different non-parametric representations, the example system described with reference to Figures 10 to 14 is configured to generate a voxel-based representation of the volume of the patterned substrate for which metrology data are available. In this case, each voxel in the generated representation is associated with a corresponding substrate volume (region of interest) in the at least one substrate. One or more numerical values are associated with each voxel, and these are indicative of material properties of the corresponding substrate volume. Advantageously, using a voxel representation, any arbitrary stack geometry can be represented. This technique is particularly useful for sensors/tools that can capture high quality information from the stack by measurement (HL-SEM, SXR), and may be less successful for sensor/tools that produce a poorer signal.

In general, the size of the volume associated with each voxel in the voxel representation may determine a "resolution" of the presentation. Figure 10 illustrates an example stack 801 (target structure), and two possible scales for voxelating (i.e. dividing into voxels) a region of interest including the target structure. They result respectively in a corresponding "low-resolution" voxel representation 802 of the region of interest, and a "high-resolution" voxel representation 803 of the region of interest. Here the darkness of the cube in each voxel represents a numerical value associated with the voxel. A high resolution may be desirable since the properties of the patterned substrate are more exactly represented.

Figure 11 shows schematically the training of the diffusion model in the non-parametric case. In this case, a substrate training element includes the ground truth substrate model 901 which is defined by substrate model data $\theta_S^i$ having at least one numerical value for each voxel. The training element is associated with metrology data which is measured data $m_i$ collected by a first metrology tool (sensor) and measured data $m_i^N$ collected by a second metrology tool (sensor). For simplicity only two kinds of measured data are shown, but there may be any number of kinds of measured data collected by different sensors and/or with different settings of the sensors (multiple different corresponding wavelengths of incident radiation (e.g. electromagnetic radiation) used by the sensor(s), multiple incidence angles, and/or multiple specific modulations of the incident radiation). Configuration data $\theta_T^i$ $\theta_T$ describes the type of the two tools and/or calibration settings of the tools at the time that the measured data was collected.

The ground truth substrate model is perturbed by a forward diffusion process of t steps of adding a noise n to give a substrate model dataset $\bar{\theta}_S^i$, which is a training item. Then a training item tuple can be formed comprising $\bar{\theta}_S^i$ (first substrate model data), $\theta_S^i$ (second substrate model data), the corresponding metrology data { $\theta_T^i$ ,$m_i$, $m_i^N$ } and the value of t. Other training items can be formed using different training elements and/or applying different noise to the same training element. In variations of Fig. 11 the metrology data may be compressed by an embedding model, as described above for the case of parametric models.

As shown in Figure 11, the perturbed substrate model data $\bar{\theta}_S^i$ and the corresponding training measurements {$m_i$, $m_i^N$ } and the configuration data $\theta_T^i$ are input to the diffusion model 900, to generate a prediction p of the perturbation n. The diffusion model 900 is trained (i.e. the values of the parameters defining the diffusion model 900 are adjusted) so as to minimize a measure of a discrepancy between the prediction p and the perturbation n (or equivalently, to minimize a measure of a discrepancy between the $\bar{\theta}_S^i$ - p and the ground truth substrate model data $\theta_S^i$ ).

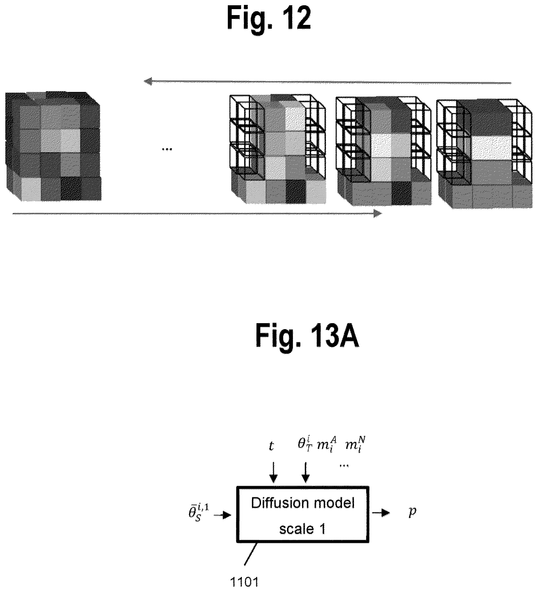

Once trained, the diffusion model 900 can be used to carry out iteratively a reverse diffusion process using the method described above with reference to Figures 8 and 9. This is illustrated in Fig. 12 where the upper arrow shows schematically the forward diffusion process which may be used to create the training items, and the lower arrow shows a reverse diffusion process performed as shown in Figures 8 and 9 to obtain, in the last iteration, substrate model data which is output as the substrate description data.

Although this example has been explained on the basis that the values defining the substrate model dataset correspond to voxels of the at least one substrate, other possibilities exist. Firstly, the substrate model dataset may comprise values associated with three-dimensional elements of the at least one substrate, but those elements may not be voxels arranged in a regular three-dimensional rectangular array; rather, they may be chosen in any way, for example as points on a different rectangular lattice, and having different sizes from each other (e.g. smaller sizes in regions where the metrology data is more precise). In this example the values are still associated with and descriptive of respective volume elements in the at least one substrate. In another possibility, the locations may be in a two dimensional-array, rather than a three-dimensional one. For example, the pattern may be formed on a surface layer of the at least one substrate, and the values may be associated with locations which are a two-dimensional array of positions on the surface, e.g. pixels in a regular two-dimensional array. The metrology data may be data obtained by imaging the surface.

Optionally, a method which is an embodiment of the present invention may include multiple phases performed using different diffusion models. In each phase except the last, data is generated and used (e.g. following an embedding) to condition the diffusion model used in the next phase.

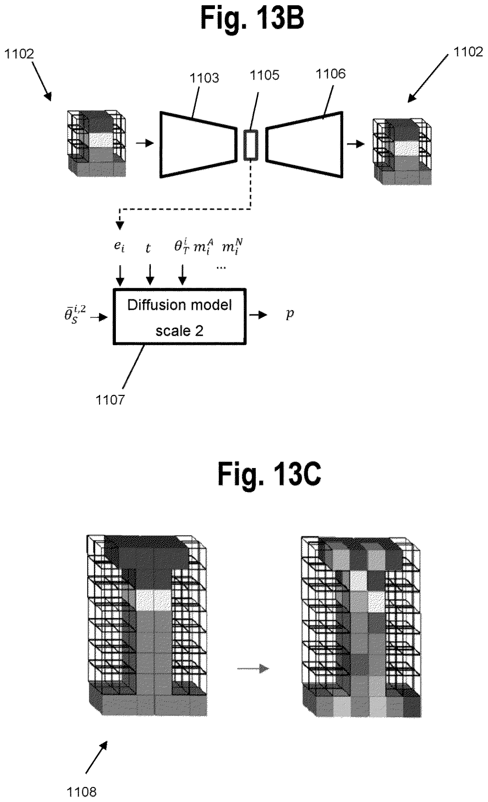

A first example is illustrated in Figure 13, which is composed of Figure 13A-C. The first phase is conducted with a first diffusion model 1101 equivalent to diffusion model 900 of Fig. 11, and trained in the same way. It receives substrate model data $\bar{\theta}_S^{i,1}$ having at least one component for each location in a three-dimensional array spanning a volume of interest in the at least one substrate. Note that this volume of interest is not necessarily contiguous, and may extend over more than one substrate. However, for simplicity, it is assumed in Figure 13 that the volume of interest is cuboidal. In a first iteration, the substrate model data $\bar{\theta}_S^{i,1}$ may be random, but the output p of the first diffusion model 1101 is used to modify $\bar{\theta}_S^{i,1}$ to form updated substrate model data. The value of t may be chosen to be the T used to form tuples in the training data of the first diffusion model 1101. In each iteration except the first, the updated substrate model data generated in the preceding iteration is input to the first diffusion model 1101, with a different value of the parameter t (e.g. t reduced by one compared to the last iteration). This process continues, as explained above, for multiple steps, and the updated substrate model data defines a "coarse" substrate model, shown as substrate model 1102 in Figure 13B.

The course substrate model 1102 is optionally embedded by an embedding (neural network) model 1103 to form an embedding $e_i$ 1105. The embedding network may be a neural network obtained, as shown in the top portion of Figure 13B, by training the embedding network 1103 as an encoder model jointly with a decoder (neural network) model 1106, such that the embedding network 1103 is trained to form an embedding 1105 which has a smaller dimensionality than the coarse substrate model 1102, and the decoder network is trained, upon receiving this embedding as an input, to reconstruct and output the coarse substrate model 1102.

In the second phase of the network, a substrate model defined by substrate model data $\bar{\theta}_S^{i,2}$ is iteratively updated by a second diffusion model 1107 which is conditioned not only on the corresponding metrology data { $\theta_{T,m_i}^i$, $m_i^N$ } and the value of t but also on the embedding $e_i$ 1105. The substrate model $\bar{\theta}_S^{i,2}$ has a greater resolution than the substrate model data $\bar{\theta}_S^{i,1}$ used in the first phase, e.g. it includes values associated with a greater number of (smaller) voxels. These voxels again correspond to locations in the region of interest, but are defined on a finer scale than the voxels of the substrate model data $\bar{\theta}_S^{i,1}$. The input to the second diffusion model 1107 in the first iteration may be selected at random. Alternatively, it may be a substrate model 1108 shown in Figure 13C which is formed from the course substrate model 1102. In each iteration, the output p of the second diffusion model 1107 is used to modify $\bar{\theta}_S^{i,2}$ to form updated substrate model data. In each iteration except the first, the updated substrate model data from the preceding iteration is input the second diffusion model 1107, with a different (e.g. one lower) value of the parameter t. This process continues, as explained above, for multiple steps. The substrate model data output by the second diffusion model 1107 in the final iteration is output as substrate description data, which is the final result of the method.

Note that the first diffusion model 1101 and the second diffusion model 1107 were obtained by a training procedure similar to the training procedure of the diffusion models 500, 900. That is, based on a training database of tuples similar to that described above: comprising a first substrate model, a second substrate model and metrology data, where the second substrate model is more consistent with the metrology data than the first substrate model. In each tuple, the first substrate model is obtained by forward diffusion from a non-parametric ground truth substrate model which may be used as the second substrate model of the tuple.

In a variation of this embodiment, the embedding network 1103 can be omitted, and the second diffusion model 1107 may be conditioned on the values of the coarse substrate model 1102. However, this variation typically may require more training data to train the second diffusion model 1107.

In another variation of this embodiment, there may be more than two diffusion models, which used in respective phases. For each phase except the first (which is as described above with reference to Figure 13A), the corresponding diffusion model is used to increase the resolution of a substrate model produced in the preceding phase, in the manner explained above with reference to Figures 13B and 13C.

Another example of a method which is an embodiment of the present invention and which includes multiple phases performed using different diffusion models, is a case which includes recognizing that the region of interest in the at least one substrate includes a semiconductor structure which is a target structure, i.e. a structure in one of a plurality of classes. That is, there are a plurality of predetermined classes, and each class includes a range of target structures. For example, each class may correspond to a certain type of electronic component, e.g. a certain form of transistor or a memory element, and the class is a set which includes a range of target structures which realize that component.

In this example, in the first phase of the method, a coarse substrate model $\bar{\theta}_S^{i,1}$ is iteratively formed in the same manner as shown in Figure 13A using a first diffusion model 1101.

After this, there is a process of recognizing, from the substrate model $\bar{\theta}_S^{i,1}$, the class of a target structure in the region of interest. This may be done automatically (i.e. substantially without human involvement, except optionally for initialization), e.g. using a trained classification system.

In a second phase, data indicative of the recognized class may be used to condition a second diffusion model. For example, the second diffusion model may be used in the same way as the second diffusion model 1107 shown in Fig. 13C, but the dataset $e_i$ which is used to condition the second diffusion model in each iteration during the second phase is indicative of the recognized class. As in Figure 13B, in the second phase second substrate model data $\bar{\theta}_S^{i,2}$ is iteratively updated, but in this implementation the second substrate model data may have the same resolution as the substrate model $\bar{\theta}_S^{i,1}$ used in the first phase. The substrate model data which is input to the second diffusion model in each iteration, is current substrate model data defining a current substrate model. In the first iteration, the input may be random, or it may be a predefined input for the recognized class. In each iteration, the diffusion model is used to generate an estimate p of the noise in the current substrate model defined by the current substrate model data $\bar{\theta}_S^{i,2}$, and the estimated noise is used to modify the current substrate model data $\bar{\theta}_S^{i,2}$, to form updated substrate model data. These steps are performed iteratively, in another realization of the method explained in Figures 8 and 9, e.g. until a convergence criterion is met. The updated substrate model data $\bar{\theta}_S^{i,c}$ generated in the last iteration is output as the substrate description data.

Optionally, the dataset $e_i$ for the recognized class may be formed from an embedding network. This may be an encoder (neural network model) trained as part of the encoder-decoder system shown in the upper part of Figure 13B, except that instead of the encoder network 1103 and decoder network 1106 being jointly trained to compress and then reconstruct coarse substrate models as in Figure 13A, they are jointly trained to compress and reconstruct respective data describing target structures in the various classes. This data may be obtained from design data for the various target structures.

In a variation of this approach, the second phase may be carried out using a second diffusion model which is not necessarily conditioned on a dataset $e_i$ indicative of the class. Instead, a respective second diffusion model may be defined for each of the plurality of classes, and trained using training items for target structures of the respective class. Based on the recognized class, the corresponding second diffusion model is selected from the plurality of pre-trained second diffusion models, and used in the second phase of the method, conditioned on metrology data for the region of interest. Thus, while the first diffusion model is to be used with multiple classes of target structure ("applications"), the second diffusion model used in the second phase may be one trained for a specific class of target structure. This means that the second diffusion model is optimized for the application. Due to this, it may be able to produce a substrate model with a given level of accuracy while being conditioned on less metrology data than if the second diffusion model was not optimized for the application. For example, the second diffusion model may be conditioned on only a (proper) subset of the metrology data used to condition the first diffusion model, for example just $\tilde{m}_i$, and the part of $\theta_T^i$ relevant to $\tilde{m}_i$, rather than the full metrology data { $\theta_T^i$, $\tilde{m}_i$, $m_i^N$ } used in the first phase. This means that the second diffusion model may have a higher throughput of data. Also, and usually more significantly, the metrology tool does not need to collect as much data, so the measurement throughput is higher, because the tool needs to spend less time measuring a given substrate location.

Another example of a non-parametric model which an implementation of the present invention may use is one in which the substrate model comprises (or consists of) an array (e.g. two- or three-dimensional) of transform components of a spatial transform model of the at least one substrate. For example, the numerical values of the non-parametric model may be Fourier components or wavelet components of a spatial transform at least one numerical physical property of the at least one substrate, such as a property (e.g. a refractive index) characterizing the interaction of an electromagnetic wave with the at least one substrate.

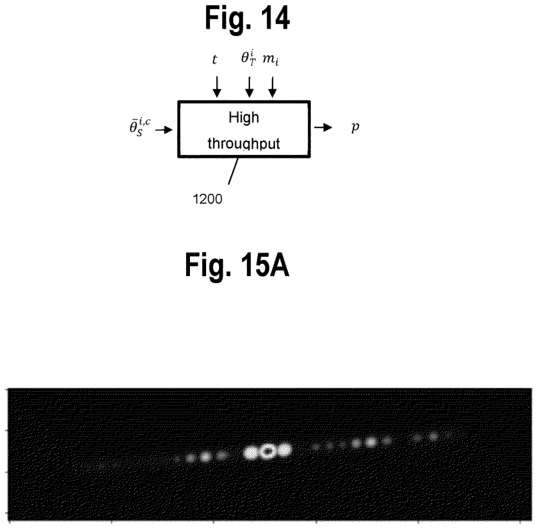

A possible form for the second diffusion model 1200 is shown in Fig. 14. It iteratively improves a substrate model defined by a substrate model dataset $\bar{\theta}_S^{i,c}$, where c is an index indicating the recognized class. The model input to the second diffusion model in each iteration is current substrate model data defining a current substrate model. In the first iteration, the input may be random, or it may be a predefined substrate model data for the recognized class. In each iteration, the diffusion model is used to generate an estimate p of the noise in the current substrate model defined by the current substrate model data $\bar{\theta}_S^{i,c}$, and the estimated noise is used to modify the current substrate model data $\bar{\theta}_S^{i,c}$. These steps are performed iteratively, in another realization of the method explained in Figures 8 and 9, e.g. until a convergence criterion is met. The updated substrate model data $\bar{\theta}_S^{i,c}$ generated in the last iteration is output as the substrate description data.

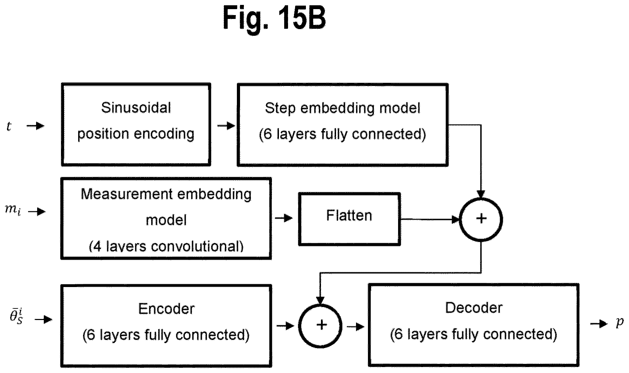

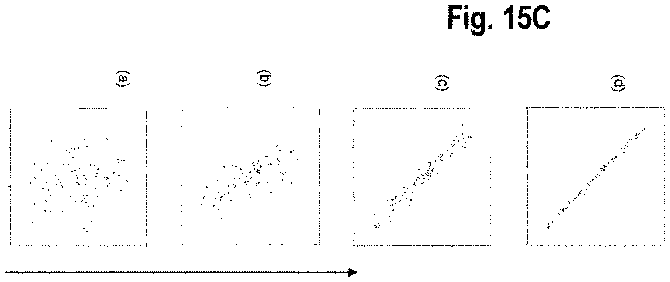

Turning to Figure 15, which is composed of Figures 15A to 15C, simulated experimental results of an embodiment of the method are presented. In this example a diffusion model is used, as explained above with reference to Figure 7, to determine the parameters of a parametric model from a measurement signal. In the simulated experiment, the measured signal was given by a specific choice for $f(\{\theta_S(i)\}, k)$ where k is a setting of a metrology tool, and i=1,...,6 labels six unknown parameters of the parametric model (i.e. for each i, $\theta_S(i)$ is one of the six parameters of the parametric model). Thus, $f(\{\theta_S(i)\}, k)$ simulates the signals of a metrology tool when measuring a stack geometry (substrate) that was parametrized by a ground truth stack geometry model represented by $\{\theta_S(i)\}$. As an example the model $f(\theta_S, k)$ can produce a two-dimensional signal as shown in Figure 15A. From the two-dimensional signal it is desired to recover the original values for $\theta_S(i)$ used to generate the signal.

Figure 15B shows the architecture of the diffusion model used in the experiment. It included a fully-connected encoder-decoder model with six layers each. It also includes additional units for pre-processing t and the metrology data. In particular, it included a signal embedding model ("measurement embedding model") which was jointly trained with the encoder-decoder of the diffusion model, using as input the simulated 2D measurements produced as explained above. The signal embedding model consisted of four convolutional layers with a stride configured to ensure a low-dimensional embedding.

The diffusion step index t was encoded using a standard sinusoidal position encoding, and the result was used as the input to an embedding model having the same architecture as the encoder. Both the diffusion step and the signal embedding were added in the latent of the encoder-decoder model. Given the simple nature of this model, 1000 step intervals were used at T for the forward diffusion process. Note that techniques such as distillation can significantly lower the number of steps needed.

Following the training of the diffusion model, successive datasets of substrate model data were obtained using the scheme of Figure 8. This gave the numerical results shown in Figure 15C, for one of the parameters and 100 target realisations. The graphs (a), (b), (c) and (d) show respective stages in the reverse diffusion process, in the order shown by the arrow. The vertical axis in each graph shows the actual value of the parameter, and the horizontal axis shows the inferred value of the parameter after a certain number of iterations of the method of Figure 8. Both are in arbitrary units. It will be seen that during the reverse diffusion process the actual values of the parameters are inferred with high accuracy.

A number of variations are possible to the embodiments described above. For example, although the embodiments employ a diffusion model, the invention may alternatively be performed using another known generative model.

For example, the generative model may be one trained in a system in which the generative model is a neural network jointly trained by adversarial learning with a discriminator (neural network). The generative model is conditioned using the metrology data in the same way as described above. In the training process, the discriminator network may be conditioned on the metrology data for training examples, and a rewards function may be defined which (a) rewards the discriminator when it can distinguish between (i) a substrate models generated by the generative model when conditioned on the metrology data, and (ii) ground truth substrate models associated with the metrology data, and (b) rewards the generative model when the discriminator fails to do this. Numerical parameters defining the generative model and the discriminator are iteratively updated to increase the reward function. In this case, step S702 of the method of Figure 9 may be performed using the trained generative model to generate a substrate model.

Optionally, the generative model may also receive as an input (both during training and in use) a current substrate model. In this case, the generative model may be used iteratively in step S702 to generate successively updated substrate models.

Further embodiments are disclosed in the subsequent numbered clauses:

1. A method of processing first metrology data of a patterned portion of at least one substrate, to generate substrate description data which characterizes a substrate model of the patterned portion of the at least one substrate, the method comprising:

i) obtaining first metrology data of the patterned portion of the at least one substrate; and
ii) generating the substrate description data based on the output of a trained generative model conditioned on the first metrology data.

2. A method according to clause 1 in which the generative model is a diffusion model and optionally said generation of the substrate description data comprises:

at least one iteration of (a) processing, by the diffusion model conditioned on the first metrology data, an input to the diffusion model comprising current substrate model data defining a current substrate model of the patterned portion of the at least one substrate, and (b) based on the output of the diffusion model generating updated substrate model data defining an updated substrate model of the portion of the at least one substrate which is more consistent with the first metrology data than the current substrate model; and
generating the substrate description data based on the updated substrate model produced in the last iteration.

3. A method according to clause 2 in which each iteration includes the steps of:

(a) using the diffusion model to generate prediction data indicative of a divergence between the current substrate model data and second substrate model data which is more consistent with the first metrology data than the current substrate model data; and

(b) generating the updated substrate model data by modifying the current substrate model data based on the prediction data.

4. A method according to clause 3, in which the pair of steps (a) and (b) are performed in each of multiple iterations, and in each iteration except the first, step (a) is performed using, as the current substrate model data, the updated substrate model data generated in step (b) of the preceding iteration.

5. A method according to clause 4 in which, in each iteration, the diffusion model is conditioned on a variable indicating the iteration.

6. A method according to any preceding clause in which the first metrology data includes (i) data output by at least one sensor by observing the patterned portion of at least one substrate, and (ii) configuration data describing the at least one sensor.

7. A method according to clause 6 in which the configuration data comprises data defining a calibration setting of the at least one sensor during the observation by the sensor of the patterned portion of the at least one substrate.

8. A method according to any preceding clause in which the generative model is further conditioned on class data indicating a class of structures present on the patterned portion of the at least one substrate.

9. A method according to any of clauses 1 to 7, comprising:

using an output of the generative model, and data characterizing one or more classes of target structures, to identify a class of target structure consistent with the first metrology data, at least one iteration of (a) processing current target model data defining a current target model of the patterned portion of the at least one substrate, with a second generative model conditioned on (i) second metrology data of the patterned portion of the at least one substrate and, and (b) based on the output of the second generative model generating updated target model data defining an updated target model of the patterned portion of the at least one substrate which is more consistent with the second metrology data than the current target model, and generating the substrate description data based on the updated target model data generated in the last iteration;

wherein the second generative model is either conditioned using data based on the identified class or is selected using the identified class as a second generative model associated with the identified class.

10. A method according to clause 9 in which the second generative model is a diffusion model, and the processing of the current target model data comprises:

generating, using the second generative model, target prediction data indicative of a divergence between the current target model data and second target model data defining a second target model which is consistent with the second metrology data than the current target model, and generating the updated target model data based on the target prediction data.

11. A method according to clause 9 or 10 in which the second metrology data comprises metrology data generated by fewer imaging modalities than the first metrology data.

12. A method according to any of clauses 8 to 11 in which the class data is generated by processing structure data descriptive of a structure of the identified class with an embedding network.

13. A method according to clause 12 in which the embedding network has been trained jointly with a decoding network within an auto-coder network, the embedding network having been trained to generate, from structure data, compressed structure data having a lower dimensionality than structure data, and the decoder network having been trained to reconstruct the structure data from the compressed structure data.

14. A method according to any preceding clause in which the substrate description data comprises one or more numerical parameters which characterize relationships between different locations in the patterned portion of the at least one substrate.

15. A method according to clause 14 in which the numerical parameters comprise at least one of:

an overlay value indicative of overlay between elements of the at least one substrate at different levels of the at least one substrate;

a value indicative of a shape of an element of the patterned structure; or

a value indicative of a discrepancy between one or more regions of the patterned structure and design data characterizing the patterned structure.

16. A method according to any preceding clause in which the substrate description data comprises one or more numerical parameters indicative of process parameters of wafer processing apparatus used to fabricate the patterned portion of the at least one substrate.

17. A method according to any preceding clause in which the substrate model comprises one or more values associated with corresponding respective locations in a region of interest in the at least one substrate and descriptive of the at least one substrate at the corresponding associated locations.

18. A method according to clause 17 in which the locations in the at least one substrate are in a three-dimensional array.

19. A method according to clause 18 in which the locations correspond to voxels of the substrate model.

20. A method according to any preceding clause in which the substrate model comprises one or more values which are spatial component values of a spatial transform of a numerical property of the substrate.

21. A method according to any of clauses 17 to 20, comprising:

obtaining second substrate model data defining a second substrate model of the region of interest and having a greater resolution than the substrate model,

at least one iteration of (a) processing current second substrate model data with a second generative model conditioned on (i) second metrology data of the patterned portion of the at least one substrate and (ii) on the updated substrate model data, and (b) based on the output of the second generative model generating updated second substrate model data defining an updated second substrate model of the patterned portion of the at least one substrate which is more consistent with the second metrology data than the current second substrate model data, and

generating the substrate description data based on the updated second substrate model data generated in the last iteration.

22. A method according to any preceding clause, wherein the patterned portion of at least one substrate has been patterned using at least one wafer processing apparatus, and the method further comprises modifying the at least one wafer processing apparatus based on the generated substrate description data.

23. A method according to clause 22 in which the wafer processing apparatus is a lithographic apparatus.

24. A method of training a diffusion model to process substrate model data defining a substrate model of a patterned portion of at least one substrate, when the diffusion model is conditioned on metrology data of the patterned portion of the at least one substrate, to generate prediction data indicative of a divergence between the substrate model data and second substrate model data which defines a second substrate model of the patterned portion of the at least one substrate which is more consistent with the metrology data than the substrate model, using a training database of training items which each comprise a tuple comprising first substrate model data, corresponding second substrate model data and corresponding metrology data;

the method comprising, for each of a plurality of the tuples, iteratively modifying one or more numerical parameters of the diffusion model to reduce a measure of the divergence between (i) noise data output by the diffusion model upon receiving the first substrate model data of the tuple and when conditioned by the metrology data of the tuple, and (ii) a difference between the second substrate model data of the tuple and the first substrate model data of the tuple.

25. A method according to clause 24 in which the metrology data of each tuple includes (i) data obtained by at least one sensor by observing the patterned portion of at least one substrate, and (ii) configuration data describing the at least one sensor.

26. A method according to clause 25 in which the configuration data comprises data defining a calibration setting of the at least one sensor during the observation by the sensor of the patterned portion of the at least one substrate.

27. A method according to any of clauses 24 to 26 in which the diffusion model is further conditioned on class data for each tuple which is indicative of a class of a target structure described by the first substrate model data, second substrate model data and metrology data of the tuple.

28. A method according to any of clauses 24 to 27 in which the diffusion model is further conditioned on data derived from a coarse substrate model having a resolution than the substrate model.

29. A method according to any of clauses 24 to 28, in which each of the tuples is associated with an index indicative of a level of noise in the first substrate model data, and the diffusion model is further conditioned on the index.

30. A method according to any of clauses 24 to 29, further comprising generating at least one tuple for the training database by, for each tuple:

at least one step of applying noise to the second substrate model data of the tuple, to generate the first substrate model data of the tuple.

31. A method according to clause 30 when dependent on clause 29 in which the index of the generated tuple indicates the number of steps in which noise was applied to the second substrate model data of the tuple to generate the first substrate model data of the tuple.

32. A method according to any of clauses 1 to 23 in which the generative model is a diffusion model trained by a method according to any of clauses 24 to 31.

33. A method according to any preceding clause, wherein the metrology data comprises after development inspection (ADI) data.

34. A method according to any preceding clause, wherein the metrology data comprises after etching inspection (AEI) data.

35. A computer program product comprising machine-readable instructions which, when the program is executed by a computer, cause the computer to carry out the method of any preceding clause.

36. A computer system comprising a processor and a data storage device, the data storage device storing program instructions which, when executed by the processor, cause the processor to carry out the method of any one of clauses 1 to 34.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

It should be appreciated that the term color is used throughout this text synonymously with wavelength or spectral component and the colors may include those outside the visible band (e.g., infrared or ultraviolet wavelengths).

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 1-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A method of processing first metrology data of a patterned portion of at least one substrate, to generate substrate description data which characterizes a substrate model of the patterned portion of the at least one substrate, the method comprising:

   i) obtaining first metrology data of the patterned portion of the at least one substrate; and
   ii) generating the substrate description data based on the output of a trained generative model conditioned on the first metrology data.

2. A method according to claim 1 in which the generative model is a diffusion model.

3. A method according to claim 1 or 2 in which said generation of the substrate description data comprises:

   at least one iteration of (a) processing, by the diffusion model conditioned on the first metrology data, an input to the diffusion model comprising current substrate model data defining a current substrate model of the patterned portion of the at least one substrate, and (b) based on the output of the diffusion model generating updated substrate model data defining an updated substrate model of the portion of the at least one substrate which is more consistent with the first metrology data than the current substrate model; and
   generating the substrate description data based on the updated substrate model produced in the last iteration.

4. A method according to claim 3 in which each iteration includes the steps of:

   (a) using the diffusion model to generate prediction data indicative of a divergence between the current substrate model data and second substrate model data which is more consistent with the first metrology data than the current substrate model data; and
   (b) generating the updated substrate model data by modifying the current substrate model data based on the prediction data.

5. A method according to any preceding claim in which the first metrology data includes (i) data output by at least one sensor by observing the patterned portion of at least one substrate, and (ii) configuration data describing the at least one sensor.

6. A method according to any preceding claim in which the generative model is further conditioned on class data indicating a class of structures present on the patterned portion of the at least one substrate.

7. A method according to any of claims 1 to 5, comprising:

   using an output of the generative model, and data characterizing one or more classes of target structures, to identify a class of target structure consistent with the first metrology data,
   at least one iteration of (a) processing current target model data defining a current target model of the patterned portion of the at least one substrate, with a second generative model conditioned on (i) second metrology data of the patterned portion of the at least one substrate and, and (b) based on the output of the second generative model generating updated target model data defining an updated target model of the patterned portion of the at least one substrate which is more consistent with the second metrology data than the current target model, and
   generating the substrate description data based on the updated target model data generated in the last iteration;
   wherein the second generative model is either conditioned using data based on the identified class or is selected using the identified class as a second generative model associated with the identified class.

8. A method according to any preceding claim in which the substrate description data comprises one or more numerical parameters which characterize relationships between different locations in the patterned portion of the at least one substrate.

9. A method according to any preceding claim in which the substrate description data comprises one or more numerical parameters indicative of process parameters of wafer processing apparatus used to fabricate the patterned portion of the at least one substrate.

10. A method according to any preceding claim in which the substrate model comprises one or more values associated with corresponding respective locations in a region of interest in the at least one substrate and descriptive of the at least one substrate at the corresponding associated locations.

11. A method according to any preceding claim in which the substrate model comprises one or more values which are spatial component values of a spatial transform of a numerical property of the substrate.

12. A method of training a diffusion model to process substrate model data defining a substrate model of a patterned portion of at least one substrate, when the diffusion model is conditioned on metrology data of the patterned portion of the at least one substrate, to generate prediction data indicative of a divergence between the substrate model data and second substrate model data which defines a second substrate model of the patterned portion of the at least one substrate which is more consistent with the metrology data than the substrate model, using a training database of training items which each comprise a tuple comprising first substrate model data, corresponding second substrate model data and corresponding metrology data;
the method comprising, for each of a plurality of the tuples, iteratively modifying one or more numerical parameters of the diffusion model to reduce a measure of the divergence between (i) noise data output by the diffusion model upon receiving the first substrate model data of the tuple and when conditioned by the metrology data of the tuple, and (ii) a difference between the second substrate model data of the tuple and the first substrate model data of the tuple.

13. A method according to any of claims 1 to 11 in which the generative model is a diffusion model trained by a method according to claim 12.

14. A computer program product comprising machine-readable instructions which, when the program is executed by a computer, cause the computer to carry out the method of any preceding claim.

15. A computer system comprising a processor and a data storage device, the data storage device storing program instructions which, when executed by the processor, cause the processor to carry out the method of any one of claims 1 to 13.

EP 4 700 481 A1

# Fig. 1

25

# Fig. 2

# Fig. 3

SC1

LA

SC3

CL

0

-1    +1

MT

SC2

SM1

2

5    10

4

Z

X

PU

W

I

6

λ

Z

8

X

# Fig. 4

Fig. 5

# Fig. 6

# Fig. 7A

$$\theta_S^i + n \rightarrow \bar{\theta}_S^i$$

$$t \quad \theta_T^i \quad m_i$$

$$\bar{\theta}_S^i \rightarrow \boxed{\begin{array}{c}\text{Diffusion model}\\ \underline{500}\end{array}} \rightarrow p \quad \approx \quad n$$

# Fig. 7B

$$\theta_S^i, \theta_T^i, m^i$$

501

# Fig. 7C

| CD1 | $10nm$ |
|-----|--------|
| CD2 | $12nm$ |
| CD3 | $14nm$ |
| H1  | $30nm$ |
| H2  | $15nm$ |
| SWA | $89°$  |

$= \theta_S^i$

# Fig. 7D

504

502    503

# Fig. 8

$$t \quad \theta_T^j \quad m_j$$

$$\hat{\theta}_{S,t} \rightarrow \boxed{\begin{array}{c} \text{Diffusion model} \\ \underline{500} \end{array}} \rightarrow p \rightarrow \boxed{\begin{array}{c} \text{remove predicted error and add} \\ \text{a small perturbation} \end{array}} \rightarrow \hat{\theta}_{S,t-1}$$

# Fig. 9

S701 → obtaining metrology data

S702 → at least one iteration of processing, by the diffusion model conditioned on the metrology data, an input comprising current substrate model data, to generate updated substrate model data

S703 → generating the substrate description model based on the updated model produced in the last iteration

# Fig. 10

Resolution scale 1

801

802

Resolution scale 2

803

# Fig. 11

901

902

$$\theta_S^i + n \rightarrow \bar{\theta}_S^i$$

$t$   $\theta_T^i$   $m_i$   $m_i^N$
$\cdots$

$\bar{\theta}_S^i$ → | Diffusion model | → $p$   $\approx$   $n$

900

# Fig. 12

# Fig. 13A

# Fig. 13B

# Fig. 13C

# Fig. 14

$$t \qquad \theta_T^i \quad m_i$$

$$\bar{\theta}_S^{i,c} \rightarrow \boxed{\begin{array}{c} \text{High} \\ \text{throughput} \end{array}} \rightarrow p$$

1200

# Fig. 15A

# Fig. 15B

$t \rightarrow$ | Sinusoidal position encoding | $\rightarrow$ | Step embedding model (6 layers fully connected) |

$m_i \rightarrow$ | Measurement embedding model (4 layers convolutional) | $\rightarrow$ | Flatten |

$\bar{\theta}_S^i \rightarrow$ | Encoder (6 layers fully connected) | Decoder (6 layers fully connected) | $\rightarrow p$

Fig. 15C

# EUROPEAN SEARCH REPORT

**Application Number**

EP 24 19 5199

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/140502 A1 (NOVA MEASURING INSTR LTD [IL]) 15 July 2021 (2021-07-15) | 1,5,6, 8-11,14, 15 | INV. G03F7/20 |
| Y | * the whole document * | 7 | |
| A | | 2-4,12, 13 | |
| X | WO 2020/193095 A1 (ASML NETHERLANDS BV [NL]) 1 October 2020 (2020-10-01) | 1,5-11, 14,15 | |
| Y | * paragraph [0070] - paragraph [0092] * | 7 | |
| A | * paragraph [0138] - paragraph [0159] * * figures 3-6 * | 2-4,12, 13 | |
| X | WO 2023/198381 A1 (ASML NETHERLANDS BV [NL]) 19 October 2023 (2023-10-19) | 1,5,6, 8-11,14, 15 | |
| Y | * paragraph [0045] - paragraph [0084] * | 7 | |
| A | * claims 1-6 * | 2-4,12, 13 | |

**TECHNICAL FIELDS SEARCHED (IPC)**

G03F

The present search report has been drawn up for all claims

| Place of search | Date of completion of the search | Examiner |
|---|---|---|
| Munich | 13 February 2025 | Maslankiewicz, Pawel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 5199

This annex lists the patent family members relating to the patent documents cited in the above-mentioned European search report.
The members are as contained in the European Patent Office EDP file on
The European Patent Office is in no way liable for these particulars which are merely given for the purpose of information.

13-02-2025

| Patent document cited in search report | Publication date | Patent family member(s) | | Publication date |
|---|---|---|---|---|
| WO 2021140502 A1 | 15-07-2021 | CN | 114930117 A | 19-08-2022 |
| | | IL | 294540 A | 01-09-2022 |
| | | KR | 20220123301 A | 06-09-2022 |
| | | TW | 202134925 A | 16-09-2021 |
| | | TW | 202401287 A | 01-01-2024 |
| | | US | 2023023634 A1 | 26-01-2023 |
| | | WO | 2021140502 A1 | 15-07-2021 |
| WO 2020193095 A1 | 01-10-2020 | CN | 113892059 A | 04-01-2022 |
| | | JP | 7256287 B2 | 11-04-2023 |
| | | JP | 7624023 B2 | 29-01-2025 |
| | | JP | 2022524970 A | 11-05-2022 |
| | | JP | 2023089034 A | 27-06-2023 |
| | | KR | 20210130784 A | 01-11-2021 |
| | | KR | 20240132400 A | 03-09-2024 |
| | | TW | 202043938 A | 01-12-2020 |
| | | TW | 202206950 A | 16-02-2022 |
| | | TW | 202316203 A | 16-04-2023 |
| | | US | 2022179321 A1 | 09-06-2022 |
| | | WO | 2020193095 A1 | 01-10-2020 |
| WO 2023198381 A1 | 19-10-2023 | CN | 119013622 A | 22-11-2024 |
| | | KR | 20250005112 A | 09-01-2025 |
| | | TW | 202405585 A | 01-02-2024 |
| | | WO | 2023198381 A1 | 19-10-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 2007224518 A
- US 2019003988 A1
- US 2019215940 A1
- US 20130304424 A1
- US 2014019097 A1, Bakeman

**Non-patent literature cited in the description**

- **LEMAILLET et al.** Intercomparison between optical and X-ray scatterometry measurements of FinFET structures. *Proc. of SPIE*, 2013, 8681